# EUROPEAN PATENT APPLICATION

(11) **EP 2 790 235 A1**
(43) Date of publication of application: **15.10.2014**
(21) Application number: 12855243.7
(22) Date of filing: 22.11.2012
(51) Int. Cl.: H01L 33/62, H05K 3/46, H05K 3/00

(54) **WIRING BOARD FOR HAVING LIGHT EMITTING ELEMENT MOUNTED THEREON**

(30) Priority: 09.12.2011 JP 2011270036
(71) Applicant: NGK Sparkplug Co., Ltd., Nagoya-shi Aichi 467-8525 (JP)
(72) Inventor: NAGAI, Makoto, Nagoya-shi Aichi 467-8525 (JP); KAWAGUCHI, Kenzo, Nagoya-shi Aichi 467-8525 (JP)
(74) Representative: Nicholls, Michael John
(86) International application number: PCT/JP2012/007536
(87) International publication number: WO 2013/084437

(57) **Abstract**

To provide a light emitting element mounting wiring substrate having a light emitting element mounting section on a substrate main body having a front surface and a back surface, and a confined component electrically connected to the light emitting element, such that the confine component does not obstruct the optical path of the light emitted from the light emitting element, resulting in uniform distribution of light intensity. The light emitting element mounting wiring substrate (1a) includes a substrate main body (2) which has a front surface (3) and a back surface (4) and which includes at least an insulating substrate (2a), and a plurality of element terminals (13, 14) formed on the front surface (3) of the substrate main body (2), at least one of the element terminals having a light emitting element mounting section (fa) on the top surface thereof, wherein the wiring substrate has a Zener diode (confined element) (10) embedded in the substrate main body (2), which element is electrically connected to a light emitting element (20) mounted on the mounting section (fa) and prevents application of overvoltage to the light emitting element (20).

## Description

### TECHNICAL FIELD

The present invention relates to a wiring substrate having a substrate main body in which a light emitting element is to be mounted on a surface of the substrate main body.

### BACKGROUND ART

There has been proposed a package for accommodating a light emitting element, the package having an insulating substrate which includes a mounting section for a light emitting element such as a light emitting diode, a mounting section for a protective element for preventing application of overvoltage to the light emitting element, and a wiring conductor for connecting the two elements; and a reflecting member which is attached to the front surface (a main surface) of the insulating substrate, which has a light-reflecting inner surface, and which surrounds the mounting section for a light emitting element. The protective element mounting section is disposed in a concavity of the insulating substrate capable of accommodating the protective element, and the concavity is defined such that the inside opening side of the protective element mounting section is located more proximal to the light emitting element side than to the surface opposite the opening (see, for example, Patent Document 1).

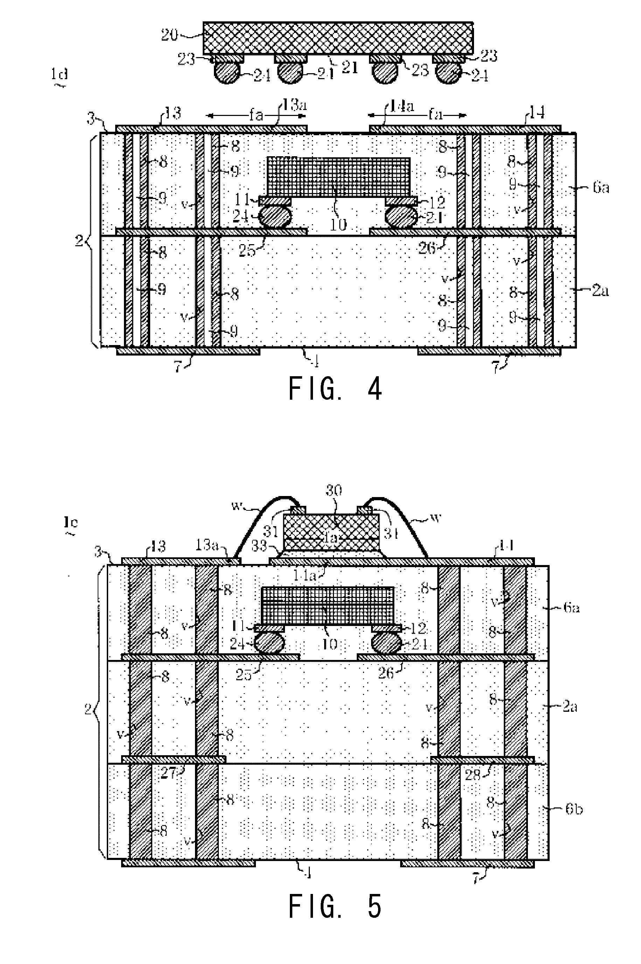

More specifically, as shown in FIG. 4 of Patent Document 1, in the disclosed light emitting element accommodation package, the protective element mounting section is provided on the bottom surface of the concavity provided in the insulating substrate so as to open to the front surface, and the light emitting element mounting section is provided at the center of the front surface of the insulating substrate surrounded by the conical reflecting member attached to the front surface of the insulating substrate.

In the case of the insulating substrate disclosed in Patent Document 1, both the light emitting element mounting section and the protective element mounting section are provided on the same front surface of the platelike wiring substrate. In such a case, the mounted protective element may obstruct the optical path of the light emitted from the light emitting element, or light radiating toward the hemispherical plane direction may have poor distribution of intensity, resulting in a drop in light emission efficiency.

In addition, as shown in FIG. 4 of Patent Document 1, when the protective element mounting section is provided on the bottom surface of the concavity opening to a peripheral region of the front surface of the insulating substrate, and the light emitting element mounting section is provided at the center of the front surface of the insulating substrate, the optical path directly above the concavity may be similarly obstructed, or the light intensity may vary between a region just above the concavity and other regions.

### PRIOR ART DOCUMENT

### PATENT DOCUMENT

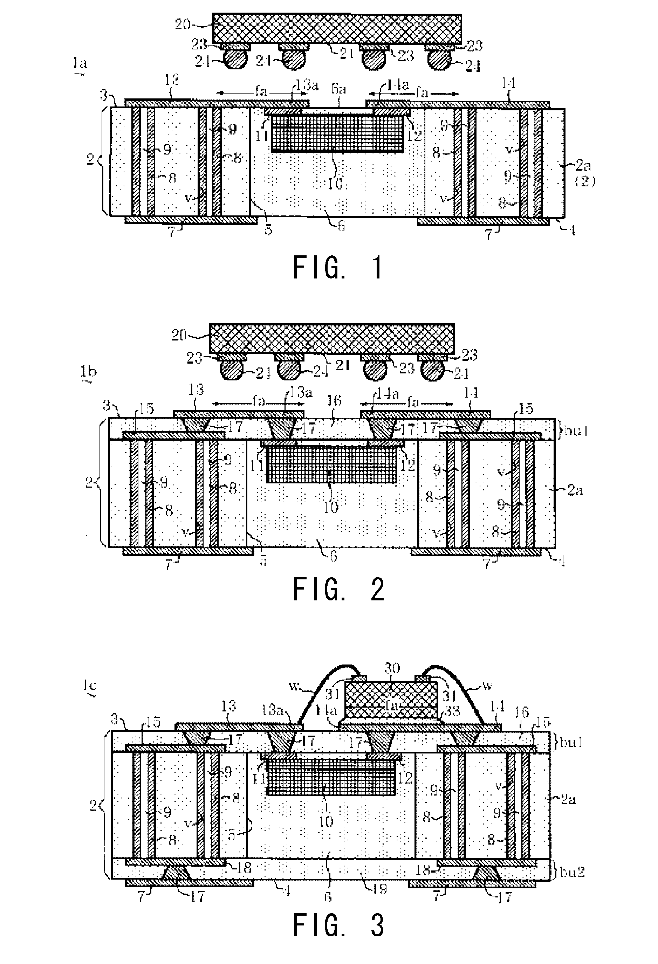

Patent Document 1: Japanese Patent No. 4789673 (p. 1 to 23, FIGs. 1 to 25)

### SUMMARY OF THE INVENTION

### PROBLEMS TO BE SOLVED BY THE INVENTION

The present invention has been accomplished for solving the aforementioned conventional problems, and an object of the present invention is to reliably provide a wiring substrate for mounting thereon a light emitting element (hereinafter the wiring substrate may be referred to as a "light emitting element mounting wiring substrate") which comprises a substrate main body having a front surface and a back surface, a light emitting element mounting section on the front surface, and an embedded component electrically connected to the light emitting element, such that the embedded component does not obstruct the optical path of the light emitted from the light emitting element, resulting in uniform distribution of light intensity.

### MEANS FOR SOLVING THE PROBLEMS

In order to attain the aforementioned object, the present invention has been conceived based on the concept that an embedded component is embedded in a substrate main body having a light emitting element mounting section on the front surface thereof.

Accordingly, a characteristic feature of the light emitting element mounting wiring substrate of the present invention comprising a substrate main body which has a front surface and a back surface and which includes at least an insulating substrate, and a plurality of element terminals formed on the front surface of the substrate main body, at least one of the element terminals having a light emitting element mounting section on the top surface thereof, resides in that an embedded element is embedded in the substrate main body, the enbedded element being electrically connected to a light emitting element component mounted on the light emitting element mounting section.

The term "embedded" refers to a state in which a embedded component is disposed inside the rectangular parallelpiped substrate main body surrounded by the front surface, the back surface, and the side surfaces, and the embedded component is not exposed to the outside.

The insulating substrate encompasses a core substrate formed of only an electrically insulating material such as a hard resin (e.g., epoxy resin) or a ceramic material (e.g., alumina), and a metal core substrate, which is made of a metal (e.g., copper alloy or stainless steel) plate having an electrically insulating coating layer on the front and back surfaces thereof and a through-hole extending from the front surface to the back surface and having an wall coated with an electrically insulating coating film.

Each of the plurality of element terminals, on which a light emitting element is to be mounted, provides about half of the area as the light emitting element mounting section. In one embodiment, one element terminal serves as a first electrode, and the other element terminal serves as a second electrode (i.e., two terminals providing a terminal pair). In another embodiment, one or more element terminals serve as a first electrode, and one or more other element terminals serve as a second electrode.

The plurality of connection terminals on the light emitting element side and the plurality of element terminals are electrically connected through soldering or brazing by the mediation of a ball grid array, or by the mediation of a bonding wire.

The light emitting element encompasses a light emitting diode and a semiconductor laser.

The embedded component encompasses, for example, a Zener diode (protective element) for preventing application of overvoltage to a mounted light emitting element; elements that control in various manners the current flowing to the light emitting element; e.g., a resistor, a capacitor and an inductance element; and parts that electrically control the light emitting element.

The light emitting element mounting wiring substrate may be in the form of a multi-piece wiring substrate array in which a plurality of wiring substrates are formed adjacent to one another in the row and column directions, as viewed in plan.

The present invention also encompasses a light emitting element mounting wiring substrate, wherein the light emitting element mounting section overlaps with at least a part of the embedded component, as viewed in plan.

In one possible form of the light emitting element mounting wiring substrate, at least the light emitting element mounting section overlaps with at least a part of the confined component, as viewed in plan, and the embedded component is provided into the substrate main body at a position relatively close to the front surface of the substrate main body.

The present invention also encompasses a light emitting element mounting wiring substrate, wherein the embedded component is embedded in the substrate main body by the mediation of a filling resin.

An example of the filling resin employed in the invention is a composite insulating material based on an epoxy resin containing about 60 mass% or more an inorganic filler such as SiO₂.

The expression "embedded by the mediation of the filling resin" refers to, for example, an insertion mode in which an element is inserted into a through-hole conductor provided in the insulating substrate forming the substrate main body, or into a concavity opening to the front surface of the insulating substrate, while the element is covered by the filling resin.

The present invention also encompasses a light emitting element mounting wiring substrate, wherein the substrate main body is formed of the insulating substrate, and a build-up layer which is stacked on at least one of the front surface and the back surface of the insulating substrate and which includes a wiring layer and a thin insulating layer; and the plurality of element terminals and a pair of component terminals of the embedded component are individually connected through via conductors extending through the thin insulating layer of the build-up layer.

The present invention also encompasses a light emitting element mounting wiring substrate, wherein the substrate main body is formed of the insulating substrate, internal wiring layers which are formed on at least one of the front surface and the back surface of the insulating substrate, and a thick insulating layer which is stacked on the at least one of the front surface and the back surface of the insulating substrate to be located on the internal wiring layers; the embedded component is embedded in the thick insulating layer; and a pair of component terminals of the embedded component are individually connected to the plurality of internal wiring layers isolated from one another.

The present invention further encompasses a light emitting element mounting wiring substrate, wherein a pair of outer connection terminals are formed on the back surface of the substrate main body, and the pair of outer connection terminals and the plurality of element terminals are electrically connected through through-hole conductors extending from the front surface of the substrate main body to the back surface of the substrate main body.

The through-hole conductors provide electrical connection between the element terminals and the outer connection terminals, and also serve as thermal-vias for dissipating the heat generated by the light emitting element to the back surface side of the substrate main body.

Examples of the through-hole conductor include a through-hole extending through the substrate main body in which a columnar conductor is inserted, and a through-hole whose wall is coated with a cylindrical conductive resin plug.

### EFFECTS OF THE INVENTION

According to the present invention, an embedded component, such as an embedded component for preventing application of overvoltage to a light emitting element, is provided inside the substrate main body including at least an insulating substrate. Thus, the embedded component does not obstruct the optical path of the light emitted from the light emitting element mounted on the front surface of the substrate main body, resulting in uniform distribution of light intensity. As a result, the light emitted by the light emitting element mounted on the front surface of the substrate main body can be effectively radiated to the outside.

According to the present invention, at least a part of the light emitting element mounted on one or more of the element terminals formed on the front surface of the substrate main body overlaps with the embedded component provided into the substrate main body, as viewed in plan. Thus, the conduction path (circuit) therebetween can be relatively shortened. As a result, the embedded component provided into the substrate main body can reliably prevent application of overvoltage to the mounted light emitting element, or can reliably control current flow to the light emitting element.

In the case where the light emitting element mounting wiring substrate is configured such that a part of the light emitting element mounting section overlaps with a part of the confined component, as viewed in plan, and the embedded component is provided into the substrate main body at a position relatively close to the front surface of the substrate main body, the conduction bath between the mounted light emitting element and the embedded component can be shortened, as viewed in plan and side.

According to the present invention, the embedded component is embedded in the substrate main body by the mediation of a filling resin. Thus, even when the substrate main body is swung by outside force or has received impact, short circuit, which would otherwise be caused by breakage or separation, can be prevented or mitigated between the embedded component and the element terminals connected to the component terminals of the embedded component or the internal wirings.

According to the present invention, a build-up layer is stacked on at least one of the front surface and the back surface of the insulating substrate forming the substrate main body. Thus, a wiring for controlling of and a circuit for supplying electric power to the embedded component and the mounted light emitting element can be added to the wiring substrate. As a result, precise control of the light emission quantity of the mounted light emitting element can be realized, along with other controls.

According to the present invention, the embedded component is embedded in the thick insulating layer, while a pair of component terminals are individually connected to internal wiring layers formed so as to be isolated from one another on at least one of the front surface and the back surface of the insulating substrate forming the substrate main body. Therefore, the embedded component can be reliably protected against unintentional outside force; application of overvoltage to the mounted light emitting element can be reliably prevented; and high-precision current flow can be realized.

According to the present invention, the heat generated by light emitting element mounted on one or more of the element terminals can be transferred to the pair of outer connection terminals formed on the back surface of the substrate main body via the through-hole conductors, and the through-hole conductors can serve as thermal-vias for dissipating the heat through the outer connection terminals to the outside. In addition, electric power can be supplied to the embedded component and the mounted light emitting element via the through-hole conductors and outer connection terminals.

### BRIEF DESCRIPTION OF THE DRAWINGS

[FIG. 1]
   FIG. 1 is a vertical sectional view of a light emitting element mounting wiring substrate according to one embodiment of the present invention.
[FIG. 2]
   FIG. 2 is a vertical sectional view of an application embodiment of the light emitting element mounting wiring substrate shown in FIG. 1.
[FIG. 3]
   FIG. 3 is a vertical sectional view of an application embodiment of the light emitting element mounting wiring substrate shown in FIG. 2.
[FIG. 4]
   FIG. 4 is a vertical sectional view of a light emitting element mounting wiring substrate according to another embodiment of the present invention.
[FIG. 5]
   FIG. 5 is a vertical sectional view of an application embodiment of the light emitting element mounting wiring substrate shown in FIG. 4.
[FIG. 6]

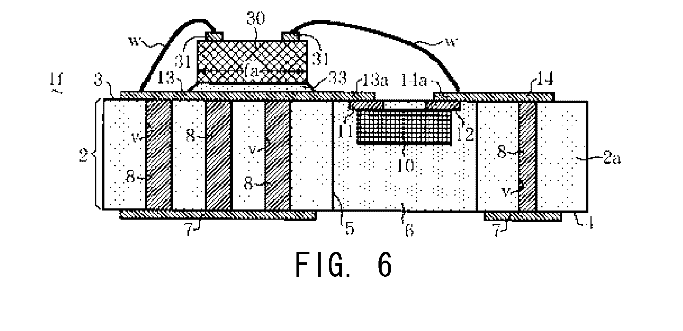

   FIG. 6 is a vertical sectional view of a light emitting element mounting wiring substrate according to still another embodiment of the present invention.

### MODES FOR CARRYING OUT THE INVENTION

A mode for carrying out the invention will now be described. FIG. 1 is a vertical sectional view showing a light emitting element mounting wiring substrate 1a according to one embodiment of the present invention, and a light emitting diode (light emitting element) 20 to be mounted thereon.

As shown in FIG. 1, the light emitting element mounting wiring substrate 1a includes a substrate main body 2 having a front surface 3 and a back surface 4 and having a platelike shape as a whole; a pair of (a plurality of) element terminals 13, 14 formed on the front surface 3 of the substrate main body 2; a pair of outer connection terminals 7 formed on the back surface 4 of the substrate main body 2; and a Zener diode (an embedded component) 10 embedded in the substrate main body 2.

The substrate main body 2 is a core substrate (electrically insulating substrate) 2a formed of a hard resin or a ceramic material and having a thickness of about 30 µm to 1000 µm. An example of the hard resin is epoxy resin. An example of the ceramic material is alumina. The substrate main body 2 has a through-hole 5 defined in the vicinity of the center thereof. The through-hole 5 is provided by means of, for example, punching such that the through-hole 5 has a rectangular shape as viewed in plan, and extends between the front surface 3 and the back surface 4.

As shown in FIG. 1, a plurality of through-holes v having a diameter of about 50 µm to 300 µm are defined in the substrate main body 2, around the through-hole 5 as viewed in plan. A through-hole conductor 8 extends along the wall surface of each through-hole v, and has a cylindrical tubular shape as a whole. An electrically conductive, circular columnar resin plug 9 formed of, for example, epoxy resin is inserted into the internal space of each through-hole conductor 8. Each through-hole conductor 8 is connected, at its upper end, to one of the element terminals 13, 17, and is connected, at its lower end, to one of the outer connection terminals 7 of opposite polarities.

The pair of element terminals 13, 14 serve as paired electrodes, and have respective light emitting element mounting sections fa on the upper surfaces of parts 13a and 14a of the element terminals 13, 14, which parts are located on the side toward the center of the front surface 3 of the substrate main body 2. The light emitting diode (light emitting element) 20 is to be mounted on the pair of light emitting element mounting sections fa. As shown in FIG. 1, solder bumps 24 are individually bonded to a plurality of external terminals 23 formed on the bottom surface 21 of the light emitting diode 20. The light emitting diode 20 can be mounted onto the element terminals 13, 14 by soldering the solder bumps 24 to the center-side parts 13a and 14a of the element terminals 13, 14. As shown in FIG. 1, the pair of light emitting element mounting sections fa (the outlines thereof) overlap with the Zener diode 10 as viewed in plan.

The Zener diode 10, which prevents application of overvoltage to the mounted light emitting diode 20, is embedded in a filling resin 6 within the through-hole 5 of the substrate main body 2, whereby the Zener diode 10 is embedded in the substrate main body 2. The Zener diode 10 has a pair of component terminals 11 and 12 on the upper surface thereof. The component terminals 11 and 12 are individually connected to the center-side parts 13a and 14a of the element terminals 13, 14 formed on the front surface 3 of the substrate main body 2. The outer connection terminals 7, the through-hole conductors 8, and the element terminals 13, 14 are formed of plating of a metal such as Cu, Ag, Ni, or Au.

The above-described light emitting element mounting wiring substrate 1a can be manufactured as follows. The through-hole 5 is formed in the core substrate 2a by means of punching or routing out, and the plurality of through-holes v are formed around the through-hole 5 by means of drilling or laser machining. Subsequently, the Zener diode 10 is inserted into the through-hole 5, and then the filling resin 6 is charged into the space around the Zener diode 10. The through-hole conductor 8 is formed along the wall surface of each through-hole v by means of a known copper plating technique, and the material of the resin plug 9 is filled into the internal space of each through-hole conductor 8. A portion of the filling resin 6 projecting from the front surface 3 of the core substrate 2a is leveled (polished) so as to expose the component terminals 11 and 12 of the Zener diode 10. Subsequently, the element terminals 13, 14 and the outer connection terminals 7 are formed on the front surface 3 and the back surface 4, respectively, of the core substrate 2a by using a known photolithography technique (patterning). In this manner, the light emitting element mounting wiring substrate 1a can be readily manufactured. The core substrate 2a may be formed to have a large size suitable for fabricating a large number of wiring substrates. In such a case, there can be fabricated a multi-piece wiring substrate array in which a plurality of wiring substrates 1a are formed adjacent to one another in the row and column directions.

In the above-described light emitting element mounting wiring substrate 1a, the Zener diode (embedded component) 10 for preventing application of overvoltage to the light emitting diode 20 is embedded in the through-hole 5 of the substrate main body 2 (i.e., the core substrate 2a) where the through-hole 5 is filled with the filling resin 6 in which the Zener diode is embedded. Thus, the Zener diode does not obstruct the optical path of the light emitted from the light emitting diode 20 mounted on the front surface 3 of the substrate main body 2, resulting in uniform distribution of light intensity. Therefore, the light can be effectively emitted to the outside of the substrate main body 2 from the light emitting diode 20, which is to be mounted on the front surface 3.

Moreover, the element terminals 13, 14 on which the light emitting diode 20 is to be mounted are connected to the pair of outer connection terminals 7 located on the back surface 4 of the substrate main body 2 via the through-hole conductors 8 having a relatively large diameter. Thus, the heat generated by the light emitting diode 20 can be effectively dissipated from the outer connection terminals 7 to the outside of the substrate main body 2, through the plurality of through-hole conductors 8 also serving as thermal-vias.

Furthermore, the Zener diode 10 as a whole overlaps with the center-side portions of the light emitting element mounting sections fa of the element terminals 13, 14, as viewed in plan, and the Zener diode 10 is embedded within the center portion on the front surface 3 side of the substrate main body 2, where the region is relatively close to the light emitting element mounting sections fa. As a result, a relatively short conductive path between the Zener diode and the light emitting element mounting sections is provided. Thus, the Zener diode 10 can reliably prevent application of overvoltage to the light emitting diode 20 to be mounted on the mounting sections.

FIG. 2 is a vertical sectional view showing a light emitting element mounting wiring substrate 1b, which is an application embodiment of the wiring substrate 1a, and a light emitting diode 20 to be mounted thereon.

As shown in FIG. 2, the light emitting element mounting wiring substrate 1b has a substrate main body 2 including a core substrate 2a, a pair of element terminals 13, 14 formed on a front surface 3 of the substrate main body 2, a pair of outer connection terminals 7 formed on a back surface 4 of the substrate main body 2, and a Zener diode 10 embedded within the substrate main body 2, these elements being formed in the same manner as described above.

As shown in FIG. 2, the substrate main body 2 is formed of the underlying core substrate 2a, and a build-up layer bu1 stacked on the front surface (top layer) of the core substrate 2a. The build-up layer bu1 is formed of a pair of wiring layers 15 spaced apart from each other on the front surface of the core substrate 2a, and a thin insulating layer 16 made of epoxy resin and having a thickness of about 100 µm. The thin insulating layer 16 is provided with a plurality of via conductors (filled vias) 17 formed therethrough. The via conductors 17 provide electrical connection between the element terminals 13, 14 and the corresponding wiring layers 15. The wiring layers 15 are formed of plating of a metal such as Cu, Ag, Ni, or Au.

The thin insulating layer 16 is also provided with similar via conductors 17, which extend between the center-side parts 13a, 14a of the element terminals 13, 14 and component terminals 11, 12 for the Zener diode 10 embedded in the through-hole conductor 5 of the core substrate 2a through embedding with the filling resin 6, thereby ensuring electrical conduction between the element terminals 13, 14 and the component terminals 11, 12. In the wiring substrate 1b, the Zener diode 10 as a whole overlaps with the light emitting element mounting sections fa (the outlines thereof) of the element terminals 13, 14, as viewed in plan.

The light emitting element mounting wiring substrate 1b is produced basically through the aforementioned method for producing the wiring substrate 1a, along with patterning to form the wiring layer 15 on the front surface of the core substrate 2a, forming the thin insulating layer 16, forming the via conductors 17, and patterning to form the element terminals 13, 14 through photolithography. In this manner, the light emitting element mounting wiring substrate 1b can be readily produced.

The light emitting element mounting wiring substrate 1b attains the aforementioned advantages of the wiring substrate 1a and has the build-up layer bu1 including the wiring layer 15. Thus, a wiring for controlling of and a circuit for supplying electric power to the Zener diode 10 confined in the substrate main body 2 and the mounted light emitting diode 20 can be added to the wiring substrate 1b. Therefore, precise control of the light emission quantity of the mounted light emitting diode 20 can be realized, along with other controls.

FIG. 3 is a vertical sectional view showing a light emitting element mounting wiring substrate 1c, which is an application embodiment of the wiring substrate 1b, and a relatively small light emitting diode 30 to be mounted thereon.

As shown in FIG. 3, the light emitting element mounting wiring substrate 1c has a substrate main body 2 including a core substrate 2a, a pair of element terminals 13, 14 formed on a front surface 3 of the substrate main body 2, a pair of outer connection terminals 7 formed on a back surface 4 of the substrate main body 2, and a Zener diode 10 embedded within the substrate main body 2, these elements being formed in the same manner as described above.

As shown in FIG. 3, the substrate main body 2 is formed of the core substrate 2a (intermediate layer), and a pair of build-up layers bu1, bu2. The build-up layer bu1 is stacked on the front surface (top layer), and the build-up layer bu2 is stacked on the bottom surface (bottom layer) of the core substrate 2a. Similar to the build-up layer bu1, the build-up layer bu2 is also formed of a pair of wiring layers 18 spaced apart from each other on the back surface of the core substrate 2a, and a thin insulating layer 19 made of epoxy resin and having a thickness of about 100 µm. The thin insulating layer 19 is provided with a plurality of via conductors (filled vias) 17 formed therethrough. The via conductors 17 provide electrical connection between the outer connection terminals 7 of the back surface 4 and the wiring layers 18. The wiring layers 18 are also formed of plating of a metal such as Cu, Ag, Ni, or Au.

Of the pair of element terminals 13, 14 formed on the front surface 3 of the substrate main body 2, the element terminal 14 (right in FIG. 3) is provided with a light emitting element mounting section fa of the top surface, and the element terminal 13 (left in FIG. 3) has no light emitting element mounting section fa. On the mounting section fa of the top surface of the right-side element terminal 14 at the center-side part 14a, a relatively small light emitting diode 30 can be mounted by the mediation of a braze material 33 or an adhesive. A pair of outer terminals 31 disposed on the top surface of the light emitting diode 30 are electrically connected to the outer peripheral portion of the right-side element terminal 14 and to the center-side part 13a of the left-side element terminal 13 via a pair of bonding wires w.

As shown in FIG. 3, a part of the light emitting element mounting section fa overlaps with a part of the Zener diode 10 embedded in the substrate main body 2 as viewed in plan.

The light emitting element mounting wiring substrate 1c is produced basically through the aforementioned method for producing the wiring substrate 1b, along with patterning to form the wiring layer 18 also on the back surface of the core substrate 2a, forming the thin insulating layer 19 by attaching resin film, forming the via conductors 17, and patterning to form the outer connection terminals 7 through photolithography. In this manner, the light emitting element mounting wiring substrate 1c can be readily produced.

The light emitting element mounting wiring substrate 1c attains the aforementioned advantages of the wiring substrate 1a and has the build-up layers bu1, bu2 including the wiring layers 15, 18. Thus, more precise control of the light emission quantity of the light emitting diode 30 can be readily realized, along with other controls.

FIG. 4 is a vertical sectional view showing a light emitting element mounting wiring substrate 1d, which is another embodiment, and a light emitting diode 20 to be mounted thereon.

As shown in FIG. 4, the light emitting element mounting wiring substrate 1d has a substrate main body 2 which is platelike as a whole and which has a front surface 3 and a back surface 4, a pair of element terminals 13, 14 formed on the front surface 3 of the substrate main body 2, a Zener diode 10 confined within the substrate main body 2, and a pair of outer connection terminals 7 formed on the back surface 4 of the substrate main body 2.

As shown in FIG. 4, the substrate main body 2 is formed of an underlying core substrate 2a, and a thick insulating layer 6a stacked on the upper layer (front surface) side of the core substrate 2a. On the front surface of the core substrate 2a, a pair of internal wiring layers 25, 26, which are separated from each other, are formed. The internal wiring layers 25, 26 are connected to the element terminals 13, 14 formed on the front surface 3 of the substrate main body 2 and to the outer connection terminals 7 formed on the back surface 4 of the substrate main body 2, through a plurality of through-hole conductors 8, which extend through the core substrate 2a and the thick insulating layer 6a. The internal wiring layers 25, 26 are also formed of a plating of a metal such as Cu or Ag.

On the front surface of the core substrate 2a, the Zener diode 10 is placed on the center-side parts of the internal wiring layers 25, 26 by the mediation of solder bumps 24. A thick resin 6a composed of an epoxy resin containing about 50 to 70 mass% an SiO₂ filler is formed so as to surround the Zener diode 10, through molding or coating operations. The through-hole conductors 8 individually connected to the internal wiring layers 25, 26 at the bottom extend through the thick resin 6a. On the front surface 3 of the substrate main body 2, which is also the front surface 3 of the thick resin 6a, a pair of element terminals 13, 14 are formed. These terminals are electrically connectable to the internal wiring layers 25, 26, the Zener diode 10, and the outer connection terminals 7, through the through-hole conductors 8 extending through the thick resin 6a and the core substrate 2a.

In the wiring substrate 1d, the Zener diode 10 as a whole overlaps with the light emitting element mounting sections fa (the outlines thereof) of the element terminals 13, 14, as viewed in plan.

According to the light emitting element mounting wiring substrate 1d, in addition to the effect of the wiring substrate 1a, the Zener diode 10 is embedded in the thick insulating layer 6a, while a pair of component terminals 11, 12 are joined to the internal wiring layers 25, 26, which are formed on the front surface of the core substrate 2a and which are isolated with each other. Therefore, the Zener diode 10 can be reliably protected against unintentional outside force, and application of overvoltage to the light emitting diode 20 mounted on the light emitting element mounting sections fa can be reliably prevented.

FIG. 5 is a vertical sectional view showing a light emitting element mounting wiring substrate 1e, which is an application embodiment of the wiring substrate 1d, and a light emitting diode 30 to be mounted thereon.

As shown in FIG. 5, the light emitting element mounting wiring substrate 1e includes a substrate main body 2 having a front surface 3 and a back surface 4 and having a platelike shape as a whole; a pair of element terminals 13, 14 formed on the front surface 3 of the substrate main body 2; a Zener diode 10 embedded in the substrate main body 2; and a pair of outer connection terminals 7 formed on the back surface 4 of the substrate main body 2.

As shown in FIG. 5, the substrate main body 2 is formed of a core substrate 2a serving as an intermediate layer, and thick insulating layers 6a, 6b stacked respectively on the top and bottom surfaces of the core substrate 2a. On the front surface of the core substrate 2a, a pair of internal wiring layers 25, 26, which are separated from each other, are formed. A plurality of via holes v, which extend through the core substrate 2a and thick insulating layers 6a, 6b along the thickness direction, are filled individually with columnar via conductors 8 formed of Cu plating. The via conductors 8 have a diameter as relatively large as about 100 to 200 µm and enables electrical interconnection involving the element terminals 13, 14, the internal wiring layers 25, 26, the Zener diode 10, and the outer connection terminals 7, and also serve as thermal vias for dissipating the heat generated by the light emitting diode 30 to the back surface 4.

As shown in FIG. 5, the element terminal 13 (left in FIG. 5) has a relatively small area, and one end of the below-described bonding wire w is connected to a center-side part 13a of the element terminal 13. The element terminal 14 (right in FIG. 5) has a relatively large area, and a light emitting diode 30 can be mounted on a light emitting element mounting section fa located at a center-side part 14a included in the top surface, by the mediation of a brazing material 33. A pair of outer terminals 31 on the tope surface of the light emitting diode 30 are individually connectable to the center-side part 13a of the element terminal 13 and to the center portion of the right-side element terminal 14 via a pair of bonding wires w.

In the wiring substrate 1e, the entire light emitting element mounting section fa of the element terminal 14 overlaps with the Zener diode 10 confined in the substrate main body 2 as viewed in plan.

According to the light emitting element mounting wiring substrate 1e, in addition to the effects of the wiring substrate 1a, 1d, the heat generated by the light emitting element 30 can be effectively dissipated from the outer connection terminals 7 on the back surface 4 side to the outside through via conductors 8 made of only a metal (Cu or Ag) and also serving as thermal vias.

FIG. 6 is a vertical sectional view showing a light emitting element mounting wiring substrate 1f, which is still another embodiment, and a light emitting diode 30 to be mounted thereon.

As shown in FIG. 6, the light emitting element mounting wiring substrate 1f has a substrate main body 2 formed only of a core substrate 2a, a pair of element terminals 13, 14 formed on a front surface 3 of the substrate main body 2, a pair of outer connection terminals 7 formed on a back surface 4 of the substrate main body 2, and a Zener diode 10 confined within the substrate main body 2.

A through-hole conductor 5 is formed in the core substrate 2a forming the substrate main body 2, and the Zener diode 10 is embedded in the through-hole conductor 5 by the mediation of a filling resin 6. Component terminals 11, 12 formed on the top surface of the Zener diode 10 are individually connected to center-side parts 13a, 14a of the element terminal 13, 14, at the front surface of the filling resin 6 which is the same level as that of the front surface 3 of the substrate main body 2.

As shown in FIG. 6, on the left portion of the front surface 3 of the core substrate 2a forming the front surface 3 of the substrate main body 2, the element terminal 13 having a relatively large area is formed. The center-side part 13a thereof partially covers the through-hole conductor 5 filled with the filling resin 6. A light emitting diode 30 is to be mounted on a light emitting element mounting section fa located at a center-side part included in the top surface, by the mediation of a brazing material 33. A pair of outer terminals 31 on the tope surface of the light emitting diode 30 are individually connectable to the center portion 14a of the right-side element terminal 14 and to an outer peripheral portion of the left-side element terminal 13 and to via a pair of bonding wires w.

As shown in FIG. 6, in the wiring substrate 1f, the light emitting element mounting section fa does not overlap with the Zener diode 10 embedded in the substrate main body 2 as viewed in plan.

However, as shown in FIG. 6, the element terminal 13 including the light emitting element mounting section fa is connected with the left-side outer connection terminal 7 (left in FIG. 6) on the back surface 4 of the substrate main body 2 through a plurality of via conductors 8 made only of a metal and having a relatively large diameter.

According to the light emitting element mounting wiring substrate 1f, the Zener diode 10 does not obstruct the optical path of the light emitted from the light emitting diode 30, resulting in uniform distribution of light intensity, and the heat generated by the light emitting diode 30 can be effectively dissipated from the outer connection terminals 7 on the back surface 4 side.

The wiring substrate 1f may be produced through the same steps as employed for producing the wiring substrate 1a.

The present invention is not limited to the aforementioned embodiments.

For example, the insulating substrate forming the substrate main body may be a metal core substrate formed of a metal plate provided with an insulating member attached to each conducing part.

Instead of the through-hole conductor 5 formed in the core substrate (insulating substrate) 2a, a concavity opening to the front surface of the core substrate 2a may be provided through counterboring, and the embedded component (10) may be embedded in the concavity by the mediation of the filling resin 6.

Instead of the light emitting diode, a semiconductor laser may be mounted on the light emitting element mounting section.

After mounting of a light emitting diode on the light emitting element mounting section fa, the diode may be covered with a sealing resin formed into a dome-like shape.

In the aforementioned wiring substrates 1a to 1f, one light emitting element and one confined component are provided. However, one confined component may be used to prevent application of overvoltage to two or more light emitting elements in parallel. Alternatively, two or more (including spare one) confined components may control in parallel conductivity of one light emitting element.

The confined component is not limited to the Zener diode and may be an element that controls the current flowing to the light emitting element; e.g., a resistor, a capacitor, or an inductance element.

In addition, each of the aforementioned wiring substrates 1a to 1f may be in the form of a multi-piece wiring substrate array (i.e., a combination of light emitting element mounting wiring substrates) in which a plurality of the same wiring substrates are formed adjacent to one another in the row and column directions, as viewed in plan.

### INDUSTRIAL APPLICABILITIES

The present invention enables and ensures provision of a light emitting element mounting wiring substrate which has a light emitting element mounting section on a front surface of a substrate main body, and a confined element electrically connected to the light emitting element, and which can prevent obstruction of the optical path of the light emitted from the light emitting element, which would otherwise be caused by the confined element, resulting in uniform distribution of light intensity.

### BRIEF DESCRIPTION OF THE REFERENCE NUMERALS

1a to 1f: light emitting element mounting wiring substrate
2: substrate main body
2a: core substrate (insulating substrate)
3: front surface
4: back surface
5: through-hole conductor
6: filling resin
6a, 6b: thick insulating layer
7: outer connection terminal
8: via conductor
10: Zener diode (embedded component)
11, 12: component terminal
13, 14: element terminal
15, 18: wiring layer
16, 19: thin insulating layer
20, 30: light emitting diode (light emitting element)
25, 26: internal wiring layer
fa: light emitting element mounting section
bu1, bu2: build-up layer

## Claims

1. A light emitting element mounting wiring substrate comprising:
a substrate main body which has a front surface and a back surface and which includes at least an insulating substrate, and
a plurality of element terminals formed on the front surface of the substrate main body, at least one of the element terminals having a light emitting element mounting section on the top surface thereof,
the wiring substrate being **characterized in that** a embedded element is embedded in the substrate main body, the embedded element being electrically connected to a light emitting element mounted on the mounting section.

2. A light emitting element mounting wiring substrate according to claim 1, wherein the light emitting element mounting section overlaps with at least a part of the embedded component, as viewed in plan.

3. A light emitting element mounting wiring substrate according to claim 1 or 2, wherein the embedded component is embedded in the substrate main body by the mediation of a filling resin.

4. A light emitting element mounting wiring substrate according to any one of claims 1 to 3, wherein the substrate main body is formed of the insulating substrate, and a build-up layer which is stacked on at least one of the front surface and the back surface of the insulating substrate and which includes a wiring layer and a thin insulating layer; and
the plurality of element terminals and a pair of component terminals of the embedded component are individually connected through via conductors extending through the thin insulating layer of the build-up layer.

5. A light emitting element mounting wiring substrate according to claim 1 or 2, wherein the substrate main body is formed of the insulating substrate, internal wiring layers which are formed on at least one of the front surface and the back surface of the insulating substrate, and a thick insulating layer which is stacked on the at least one of the front surface and the back surface of the insulating substrate to be located on the internal wiring layers, and
the embedded component is embedded in the thick insulating layer, and a pair of component terminals of the embedded component are individually connected to the plurality of internal wiring layers isolated from one another.

6. A light emitting element mounting wiring substrate according to any one of claims 1 to 5, wherein a pair of outer connection terminals are formed on the back surface of the substrate main body, and the pair of outer connection terminals and the plurality of element terminals are electrically connected through through-hole conductors extending from the front surface of the substrate main body to the back surface of the substrate main body.

## Amended claims

### Amended claims under Art. 19.1 PCT

**1.** (Amended) A light emitting element mounting wiring substrate comprising:
a substrate main body which has a front surface and a back surface and at least an insulating substrate, and a build-up layer which is stacked on at least one of the front surface and the back surface of the insulating substrate and which includes a wiring layer and a thin insulating layer;
a plurality of element terminals formed on the front surface of the substrate main body, at least one of the element terminals having a light emitting element mounting section on the top surface thereof,
the wiring substrate being **characterized in that** a embedded element is embedded in the substrate main body, the embedded element being electrically connected to a light emitting element mounted on the mounting section, and
the plurality of element terminals and a pair of component terminals of the embedded component are individually connected through via conductors extending through the thin insulating layer of the build-up layer.

**2.** A light emitting element mounting wiring substrate according to claim 1, wherein the light emitting element mounting section overlaps with at least a part of the embedded component, as viewed in plan.

**3.** A light emitting element mounting wiring substrate according to claim 1 or 2, wherein the embedded component is embedded in the substrate main body by the mediation of a filling resin.

**4.** (Deleted)

**5.** (Amended) A light emitting element mounting wiring substrate comprising:
a substrate main body which has a front surface and a back surface and at least an insulating substrate, internal wiring layers which are formed on at least one of the front surface and the back surface of the insulating substrate, and a thick insulating layer which is stacked on the front surface side of the insulating substrate to be located on the internal wiring layers; and
a plurality of element terminals formed on the front surface of the substrate main body, at least one of the element terminals having a light emitting element mounting section on the top surface thereof,
the wiring substrate being **characterized in that** a embedded element is embedded in the thick insulating layer, the embedded element being electrically connected to a light emitting element mounted on the mounting section, and a pair of component terminals of the confined component are individually connected to the plurality of internal wiring layers isolated from one another.

**6.** (Deleted)

**7.** (Added) A light emitting element mounting wiring substrate according to claim 5, wherein the light emitting element mounting section overlaps with at least a part of the confined component, as viewed in plan.

**8.** (Added) A light emitting element mounting wiring substrate according to any one of claims 1 to 7, wherein a pair of outer connection terminals are formed on the back surface of the substrate main body, and the pair of outer connection terminals and the plurality of element terminals are electrically connected through through-hole conductors extending from the front surface of the substrate main body to the back surface of the substrate main body.

The new claim 1 is based on the claim 1 and 4, consequently the claim 4 is canceled. The new claim 5 is based on the claim 1 and the claim 5. The new claim 7 is based on claim 2. The new claim 8 is based on the claim 6, consequently the claim 6 is canceled. The claim 2 and the claim 3 is uncharged.
